# EUROPEAN PATENT APPLICATION

(11) **EP 4 333 585 A1**
(43) Date of publication of application: **06.03.2024**
(21) Application number: 22193341.9
(22) Date of filing: 31.08.2022
(51) Int. Cl.: H05K 13/00

(54) **CARRIER POSITIONING DEVICE**

(71) Applicant: Nexperia B.V., 6534 AB Nijmegen (NL)
(72) Inventor: Alessandro, Mazza, 6534AB Nijmegen (NL); Ellenbroek, Tim, 6534AB Nijmegen (NL)
(74) Representative: Pjanovic, Ilija

(57) **Abstract**

Aspects of the present disclosure relate to a carrier positioning device for positioning a carrier, such as a printed circuit board, and to a pick-and-place device comprising the same. Aspects of the present disclosure further relate to a method for positioning a carrier, such as a printed circuit board, and to a method for arranging an electrical component on a carrier. The carrier comprises a first surface and a second surface, wherein the first surface comprises a first central region on which electrical components are to be arranged, and a first edge region adjacent to the first central region.

According to an aspect of the present disclosure, the carrier is flattened on a flattening side of a flattening member. The flattening member with the carrier on the flattening side is moved such that the carrier is pressed with its first surface against a flat abutment side of an abutment member. The abutment member is configured to leave an opening exposing the first central region when the carrier is in abutment with the flat abutment side.

## Description

### FIELD

Aspects of the present disclosure relate to a carrier positioning device for positioning a carrier, such as a printed circuit board, and to a pick-and-place device comprising the same. Aspects of the present disclosure further relate to a method for positioning a carrier, such as a printed circuit board, and to a method for arranging an electrical component on a carrier.

### BACKGROUND

In the field of semiconductor technology, electrical components are often required to be placed on a carrier. For example, for constructing a display panel or light panel, a plurality of light-emitting diodes, LEDs, for example as bare semiconductor dies, need to be arranged on a carrier in the form of a printed circuit board, PCB, using a so-called die attach process.

Typically, a carrier comprises a first surface and a second surface, wherein the first surface comprises a first central region on which electrical components are to be arranged, and a first edge region adjacent to the first central region. The first edge region can be mechanically manipulated for positioning the carrier.

The die attaching process includes a post-bond inspection, which is performed using a camera that takes a photo of the semiconductor die that has just been placed. This photo is then used to evaluate the accuracy of the placement and for adjusting the machine parameters for the next die.

The depth of field of the cameras in the inspection module is +/- 60 micrometer. The top surface of the PCB must be positioned within +/- 60 micrometer with respect to these cameras. This distance must not change at different positions of the same PCB, and in-between different PCBs.

PCBs are manufactured following specific standards. These standards set limits for the maximum bow and twist of the PCB. For example, according to the IPC-A-600 standard, the maximum bow and twist should be less than 0.75% of the PCB diagonal. This means, for example, that for a 250x250 mm PCB, a maximum bow/twist of 2.65 mm can be expected. Another limit set by the IPC-A-600 standard relates to the thickness accuracy, which should be less than +/- 0.1mm. It should be noted that this thickness accuracy relates to the variation in thickness between different PCBs. Both these values affect the tolerance stack and are well over the requested +/- 60 micrometer.

### SUMMARY

Aspects of the present disclosure relate to a carrier positioning device for positioning a carrier, such as a printed circuit board, in which the abovementioned problem is mitigated. To that end, the carrier positioning device comprises an abutment member having a flat abutment side, a flattening member having a flattening side, a flattening unit, and a first actuator. The flattening unit is configured to flatten the carrier with its second surface against the flattening side. The first actuator is configured to move the flattening member with the carrier on the flattening side such that the carrier is pressed with its first surface against the flat abutment side. Furthermore, the abutment member is configured to leave an opening exposing the first central region when the carrier is in abutment with the flat abutment side to allow electrical components to be arranged on the first central region while the carrier is clamped between the abutment member and flattening member. Examples of electrical components to be arranged on the carrier are bare semiconductor dies or packaged semiconductor dies.

According to an aspect of the present disclosure, the carrier is flattened using a flattening unit. This ensures that bow and twist of the carrier are sufficiently removed. In addition, the first actuator ensures that the first surface of the carrier, on which the electrical components are to be arranged, is pressed against the flat abutment side of the abutment member.

The abutment member has a well-defined position. For example, the abutment member is stationarily arranged with respect to an optical camera of an inspection module as described above. Additionally or alternatively, the abutment member is stationarily arranged relative to a supporting surface on which the carrier positioning device is arranged. Accordingly, by pressing the carrier against the flat abutment side, the position of the first surface of the carrier falls within a range that allows proper operation of the inspection cameras.

The flattening unit can be configured to flatten the carrier before the first actuator has moved the flattening member against the flat abutment side. Alternatively, the first actuator is configured to move the carrier against the flat abutment side thereby obtaining an initial flattening of the carrier before the flattening unit performs a further flattening of the carrier.

The first actuator may be a manual first actuator and may comprise a lever. Alternatively, the first actuator may be an automatic actuator. Furthermore, the carrier positioning device may comprise a controller for controlling the first actuator and/or the flattening unit.

The carrier to be positioned may comprise one or more electrical components arranged on the second surface thereof, wherein the flattening side comprises one or more component accommodation openings through which the one or more electrical components arranged on the second surface of the carrier extend when the carrier is arranged on the flattening side. Accordingly, the present disclosure also allows carriers to be used of which one side or surface is already occupied by one or more electrical components. As the placement of the components is product specific, i.e. each product may have its own configuration of electrical components, the flattening member typically has to be replaced whenever a new type of product needs to be manufactured.

The flattening unit may comprise a vacuum unit. In this case, the flattening side may comprise one or more vacuum openings, wherein the vacuum unit is configured for exerting a suction force through the one or more vacuum openings of the flattening side to thereby flatten the carrier. At least some of the vacuum openings can be component accommodation openings or vice versa.

According to an aspect of the present disclosure, the operation of the device can be separated in several actions. A first action may comprise the bringing the carrier and the flattening side close together. A second action may comprise the flattening of the carrier on the flattening side, and a third action may comprise moving the flattening member with the carrier arranged on the flattening side towards the flat abutment, and a fourth action may comprise pressing the carrier against the flat abutment surface. These latter two actions are generally combined. For example, the first actuator can be used for moving the flattening member towards the flat abutment surface. By allowing this drive to continue after abutment has been achieved, a continuing pressing force can be exerted onto the carrier, at least during placement of the electrical components on the first surface of the carrier and the associated inspection.

The first two actions, i.e. bringing the carrier and the flattening side close together, and the second action, i.e. flattening the carrier, can both be performed by the flattening unit. For example, in case the flattening unit comprises a vacuum unit, application of the suction force may result in the carrier being drawn towards the flattening side, and, once the carrier lies against the flattening side, causes the carrier to be flattened. In other embodiments, additional means are used for bringing the carrier and the flattening side close together.

It is also possible that the second action is performed as part of and/or during the fourth action. For example, by pressing the carrier against the flat abutment side, an initial flattening of the carrier is obtained. The flattening unit may be used to flatten the carrier further after the initial flattening has been obtained.

The flattening member may comprise a vacuum chamber of which a first wall defines the flattening side, wherein the one or more vacuum openings and the one or more component accommodation openings, if present, are provided in the first wall, and wherein the vacuum unit is configured to evacuate the vacuum chamber. In this embodiment, the flattening side can be formed by a flat wall, such as a plate of aluminum or stainless steel, that is provided with the vacuum openings, and optionally, the one or more component accommodation openings. The flat wall provides a supporting function when flattening the carrier against the flat wall.

Alternatively, the flattening member may comprise a bottom wall, a plurality of side walls extending from the bottom wall, and a plurality of posts extending from the bottom wall towards the flattening side, wherein the bottom wall and the plurality of side walls define a chamber together with the carrier when the carrier is arranged on the plurality of posts. This chamber is connected to the vacuum unit. In this embodiment, the flattening side is not formed by a flat wall as in the previous embodiment. Rather, the flattening side is formed by the ends of the posts. During flattening, the carrier rests on these ends. Moreover, a clearance between the plurality of posts may form the one or more component accommodation openings of the flattening side, if needed. The suction force that can be generated when the space between the bottom wall and the side walls is evacuated prior to the carrier being arranged fully on the posts may be insufficient for bringing the carrier and flattening side close enough together. If needed, the flattening member may comprise a plurality of suction cups mounted to the bottom wall. Each suction cup may provide a channel between an inlet opening and an outlet opening of the suction cup, wherein the outlet openings of the suction cups define the one or more vacuum openings, and wherein the inlet openings are connected to the vacuum unit. The use of vacuum cups ensures a more focused generation of the suction force and may be used in addition to or instead of a vacuum chamber.

The suction cups can be flexible in a direction from the bottom wall towards the flattening side such that prior to arranging the carrier on the plurality of posts, the outlet openings of the suction cups are positioned more remote from the bottom wall than ends of the plurality of posts, and such that during flattening the carrier, a length of the suction cups has contracted. Due to the contractable length, it becomes possible to exert an attracting force onto the carrier from a greater distance.

Instead of the vacuum unit being connected to a chamber or vacuum chamber as defined above, the flattening member may comprise a container having an open side and a porous body arranged in the container, wherein a first side of the porous body corresponding to the open side of the container forms the flattening side, and wherein pores of the porous body exiting on the first side of the porous body form the one or more vacuum openings, and wherein the vacuum unit is configured to evacuate the pores of the porous body. The porous body is configured such that the pores inside the body are generally interconnected. In this way, evacuating a pore at one side of the porous body results in the generation of a suction force at the first side of the porous body. It is noted that the container in this case merely closes off the pores of the porous body at the sides other than the first side and the connection of the vacuum unit.

As mentioned above, the first and second actions may not be performed using the same components. As an example thereof, the carrier positioning device may further comprise a pushing unit that is configured to push the carrier towards the flattening side prior to flattening the carrier. This pushing unit may be movable such that it can be removed from the space above the first surface of the carrier so that it does not impede the placement of one or more electrical components on the first surface of the carrier. The pushing unit may for example comprise a cylinder having a movable piston for exerting a force onto the carrier. Additionally or alternatively, the pushing unit may comprise a resilient member arranged fixedly relative to the abutment member. This resilient member can be configured to be compressed by the carrier when the carrier is moved towards the abutment member. In this case, the action of flattening the carrier can be performed when moving the flattening member towards the abutment member. For example, the carrier can be arranged on the flattening side. At this stage, the flattening member may not yet be able to fully flatten the carrier. For example, an amount of bow or twist of the carrier is too large so that the suction force is insufficient for fully flattening the carrier. When moving the flattening member toward the abutment member, the first surface of the carrier is engaged by the resilient member. One end of this member is fixedly attached. The other end presses onto the carrier thereby bringing the carrier closer to the flattening side and at the same time partially flattening the carrier. Once sufficiently flattened, a better sealing is obtained between the carrier and the flattening side, thereby increasing the suction force allowing the carrier to be flattened further.

Instead of a vacuum unit, the flattening unit may comprise a pair of edge engaging members for engaging the edge of the carrier, and a second actuator for rotating the engaging members. The flattening member may comprise a base and a plurality of posts extending from the base to the flattening side. The second actuator can be configured to cause the carrier to bulge towards the flattening side. In this case, the second actuator can be further configured to mutually move the carrier with the engaging members and the flattening member to bring the plurality of posts into abutment with the second surface of the carrier such that the carrier is flattened. The flattening action is in this case obtained by the force exerted by the engaging members urging the carrier to bulge and the counterforce exerted by the posts. By properly balancing these forces, the carrier can be flattened. By using multiple engaging members arranged at different positions along the edge of the carrier and by controlling these engaging members individually, it becomes possible to correct for a twist in the carrier. Similar to the first actuator, the second actuator can be a manual actuator or an automatic actuator. In the latter case, the actuator may be controlled by the aforementioned controller.

The abutment member can be movable in a plane parallel to the flattening side between a first position in which the carrier can be arranged on the flattening side, and a second position in which the carrier can be pressed against the abutment surface. For example, the abutment member may comprise separate parts for at least two edges of the carrier. By moving these parts away from each other, area is created to arrange the carrier on the flattening side or to bring it into close vicinity therewith.

According to a further aspect of the present disclosure, a pick-and-place apparatus is provided that comprises the carrier positioning described above that is configured for positioning a carrier. It further comprises a pick-and-place unit configured for picking an electrical component from a supply of electrical components and for placing the picked electrical component onto the first central region of the first surface of the carrier while the positioning device clamps the carrier between its abutment member and flattening member.

According to a further aspect of the present disclosure, a method is provided for positioning a carrier, such as a printed circuit board. The carrier comprises a first surface and a second surface, wherein the first surface comprises a first central region on which electrical components are to be arranged, and a first edge region adjacent to the first central region.

The method comprises flattening the carrier on a flattening side of a flattening member, and moving the flattening member with the carrier on the flattening side such that the carrier is pressed with its first surface against a flat abutment side of an abutment member. The step of flattening the carrier may be performed before moving the flattening member. Alternatively, pressing the carrier against the flat abutment side can be performed first, which will cause an initial flattening. Further flattening may be obtained thereafter. In addition, the abutment member is configured to leave an opening exposing the first central region when the carrier is in abutment with the flat abutment side.

According to an even further aspect of the present disclosure, a method is provided for arranging an electrical component on a carrier, comprising the abovementioned method, and arranging the electrical component on the first central region of the first surface while the carrier is clamped between the abutment member and flattening member.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates a schematic top view of a positioning device according to an aspect of the present disclosure;
Figure 2 illustrates an electronic component mounted on a PCB that is inspected using an optical camera;
Figure 3 illustrates an example of a flattening member of a carrier positioning device in accordance with an aspect of the present disclosure;
Figures 4 - 10 illustrate different embodiments of a carrier positioning device in accordance with an aspect of the present disclosure; and
Figure 11A and 11B illustrate two methods in accordance with further aspects of the present disclosure.

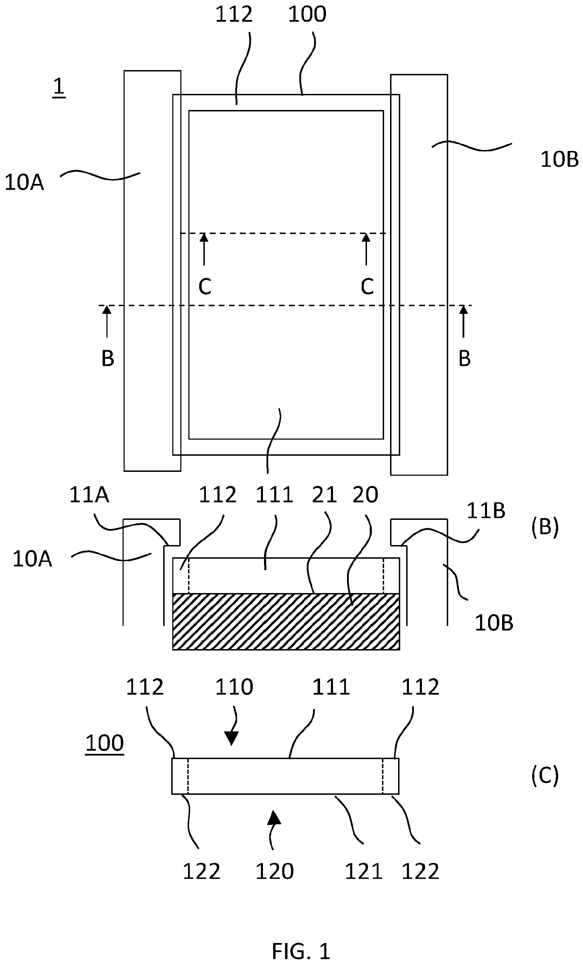

Figure 1, top, illustrates a schematic top view of a positioning device 1 according to an aspect of the present disclosure. It comprises an abutment member 10A, 10B, and a flattening member 20 having a flattening side 21. A carrier 100 in the form of a PCB is arranged on flattening side 21.

In figure 1, reference signs 10A, 10B are used for referring to two parts of the abutment member. Furthermore, additional parts may be provided for engaging the upper and lower parts carrier 100.

Carrier 100 has a first surface 110 and a second surface 120. First surface 110 comprises a central region 111 and an edge region 112 that surrounds central region 111. Similarly, second surface 120 comprises a central region 121 and an edge region 122 that surrounds central region 121. In figure 1, central regions 111, 121 have an identical shape and size. However, the present disclosure is not limited to this configuration.

Electrical components are to be arranged on central region 111, whereas edge region 112 remains free of electrical components and can be manipulated mechanically for handling carrier 100. Electrical components can be arranged on second central region 121, prior to the arranging electrical components on central region 111.

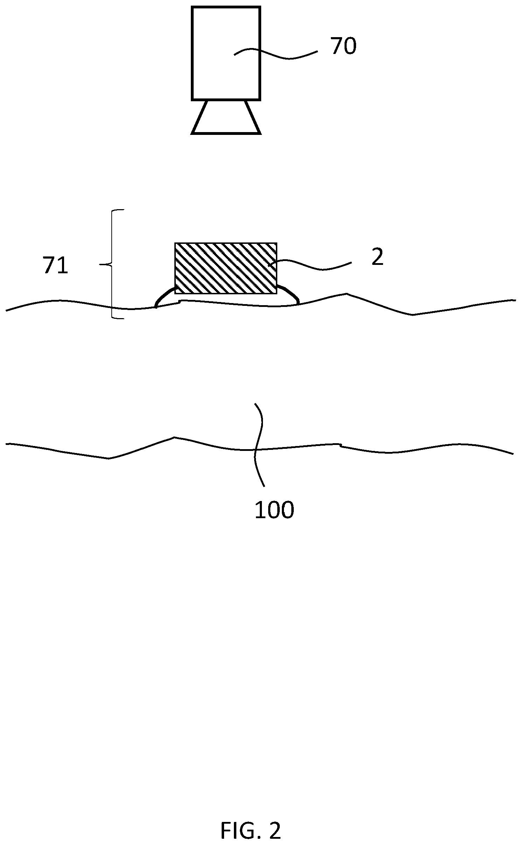

As shown in figure 1, top, abutment member 10A, 10B has a flat abutment surface 11A, 11B. Surfaces 11A, 11B are configured to abut and/or lie against edge region 112 of carrier 100. Surfaces 11A, 11B have a well-defined position. For example, positioning device 1 may be arranged on a supporting floor and/or may comprise a stationary frame. The position of surfaces 11A, 11B is fixed relative to the supporting floor and/or stationary frame. Alternatively, surfaces 11A, 11B may have a well-defined constant position relative to an optical camera 70 that is used for inspection as will be explained later referring to figure 2.

Abutment member 10A, 10B is configured to leave an opening exposing central region 111 when carrier 100 is in abutment with flat abutment side 11A, 11B to allow electrical components to be arranged on central region 111 while carrier 100 is clamped between abutment member 10A, 10B and flattening member 20.

Carrier 100 is not a perfectly flat structure. For example, PCBs may have a thickness variation over the PCB of +/- 15 microns. The PCB may further have an average thickness that varies between different PCBs within a range of +/- 100 micron relative to a nominal value, and a maximum bow and maximum twist of 0.75% of the PCB diagonal.

Carrier positioning device 1 is part of a pick-and-place device although the present disclosure does not exclude other application areas of carrier positioning device 1. As shown in figure 2, the pick-and-place apparatus comprises an optical camera 70 that has a particular depth-of-field 71. Optical camera 70 is configured for inspecting placement and attachment of electrical component 2 to carrier 100. For example, optical camera 70 may inspect whether electrical component 2 has been placed at an intended position and/or may inspect whether the electrical contact between electrical component 2 is reliable.

For most high throughput systems, an optical camera is used that has a relatively small depth-of-field 71. As optical camera 70 has a fixed position relative to a frame of the carrier positioning device and/or to a supporting surface on which this device is arranged, and because carrier 100 is subject to the abovementioned tolerances, the position of electrical component 2 in a direction perpendicular to carrier 100 will vary from component to component and from carrier to carrier. The carrier positioning device according to an aspect of the present disclosure enables the carrier to be sufficiently flattened such that during operation, electrical component 2 remains within depth-of-field 71 of optical camera 70.

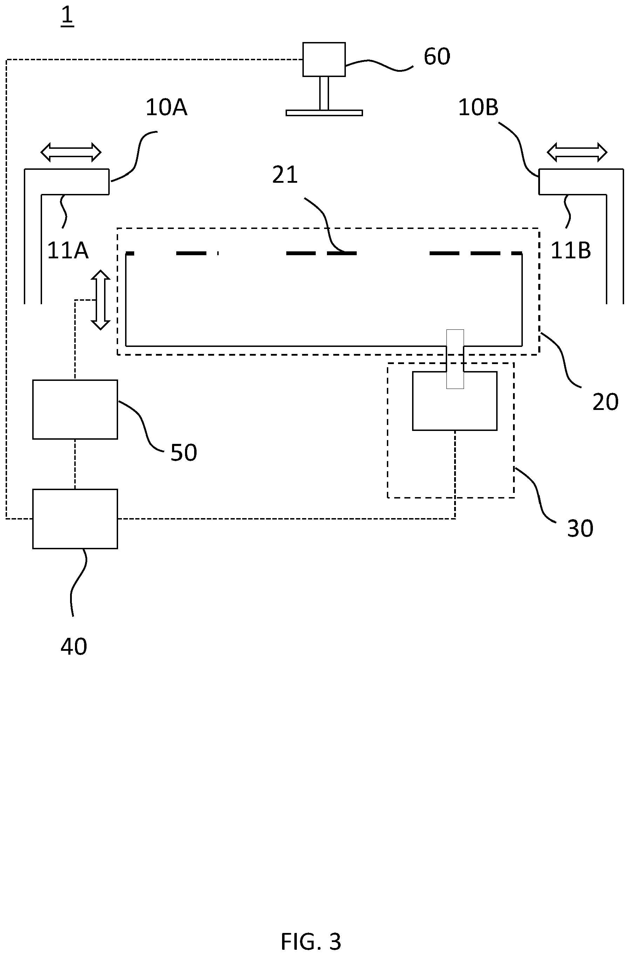

To flatten carrier 100, carrier positioning device 1, comprises, in addition to an abutment member and flattening member of which examples were shown in figure 1, a flattening unit, and a first actuator, and a controller. These components are schematically illustrated in figure 3.

Controller 40 is configured for controlling flattening unit 30 such that carrier 100 is flattened with its second surface 120 against flattening side 21 of flattening member 20, and for controlling first actuator 50 to move flattening member 20 with carrier 100 on flattening side 21 such that carrier 100 is pressed with its first surface 110 against flat abutment side 11A, 11B.

Controller 40 may further control a pushing unit 60 that is able to push carrier 100 in a direction towards flattening member 20. In other embodiments, controller 40 can be omitted or is not used for controlling each of the components mentioned above. For example, first actuator 50 may be a manual actuator that a user may operate. Similarly, flattening unit 30 can be operated directly by a user, i.e. without controller 40.

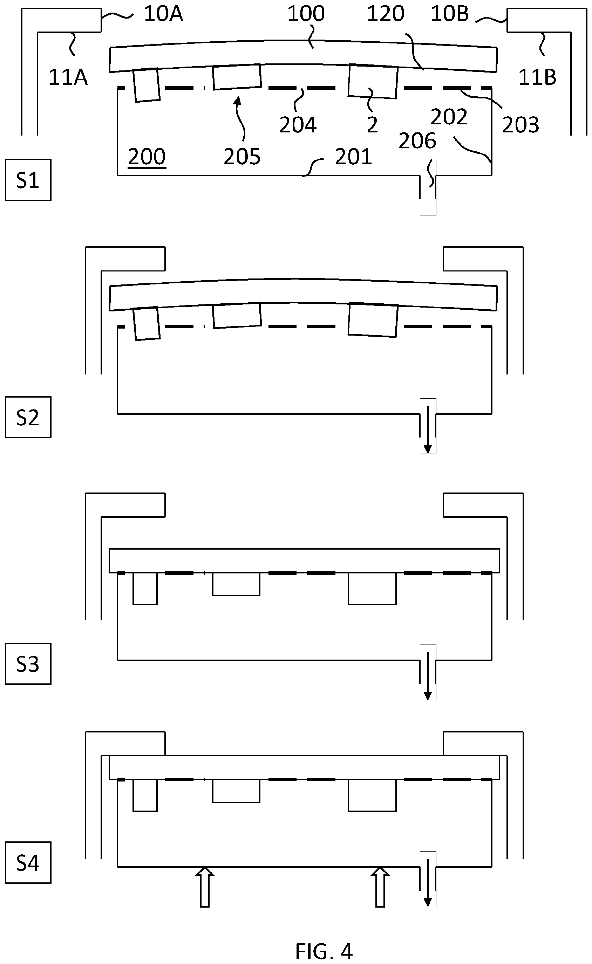

Figure 3 illustrates an embodiment in which flattening member 20 is configured as a vacuum chamber and flattening unit 30 as a vacuum pump. The operational principles of this embodiment as well as other embodiments will be explained referring to figures 4-9.

Figure 4 illustrates an embodiment in which flattening unit comprises a vacuum pump (not shown) and in which flattening member 20 comprises a vacuum chamber 200 that includes a bottom wall 201, sidewalls 202, and a top wall 203. Vacuum chamber 200 is further provided with an inlet connected to the vacuum pump.

In this embodiment, flattening side 21 of flattening member 20 is formed by top wall 203. This latter wall is provided with openings 204 and openings 205.

The process of flattening carrier 100 will now be described referring to figure 4, wherein the different stages are indicated using S1-S4, wherein each stage is represented by a corresponding figure.

In stage S1, carrier 100, which is provided with electrical components 2 on second surface 120, is arranged on flattening side 21, more in particular on top wall 203. More in particular, carrier 100 is arranged such that electrical components 2 are arranged at least partially through openings 205, which are referred to as component accommodation openings.

Next, in stage S2, abutment member 10A, 10B is moved to a position in which it is able to engage carrier 100 at a later stage. The process of moving abutment member 10A, 10B may be automatic, for example controlled by controller 40, or it may be performed manually. After arranging carrier 100 on flattening side 21 and after or before moving abutment member 10A, 10B, vacuum chamber 200 is evacuated in stage S2.

The application of vacuum in vacuum chamber 200 allows a suction force to be generated that is exerted onto carrier 100 through openings 204, 205. As shown in stage S3, this results in carrier 100 to become flattened.

Next, in stage S4, flattening member 20 and carrier 100 arranged thereon are moved towards abutment member 10A, 10B using an actuator (not shown) controlled by controller 40. After contact is made between carrier 100 and abutment surfaces 11A, 11B, an upward force is maintained such that carrier 100 becomes clamped between flattening side 21 of flattening member 20 and abutment member 10A, 10B. Due to the flattening, bow and twist of carrier 100 can be mitigated. Furthermore, due to abutment against abutment surfaces 11A, 11B, the top surface of carrier 100 is at a well-defined position. The combination of these aspects results in the position of the electrical components that are to be arranged on carrier 100 to be within acceptable ranges for fixedly mounted inspection cameras.

In an embodiment, the order of stages S3 and S4 may be reversed. More in particular, carrier 100 can first be arranged on flattening side 21 without evacuating vacuum chamber 200 at that time. Instead of evacuating vacuum chamber 200, flattening member 20 is first moved with its flattening side 21 against abutment member 10A, 10B. This will result in an initial flattening. Full flattening is achieved by evacuating vacuum chamber 200.

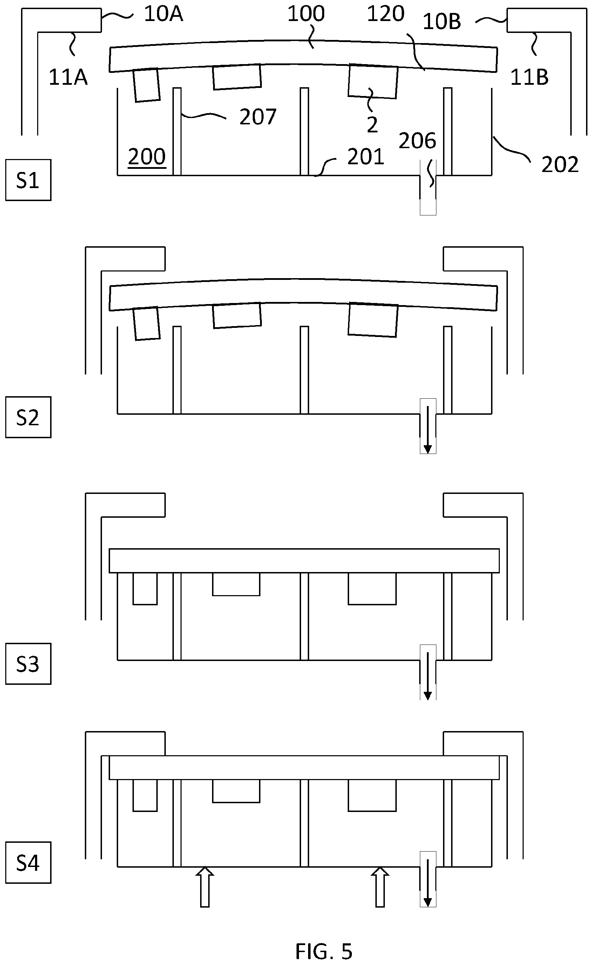

Figure 5 illustrates a different embodiment of a carrier positioning device. Compared to figure 4, chamber 200 no longer comprises a top wall 203. To still provide a supporting function, chamber 200 comprises a plurality of posts 207 that extend upwards from bottom wall 201. In this case, flattening side 21 is formed by the ends of posts 207. The space between posts 207 serves to accommodate electrical components 2.

The presence of bow and twist may cause carrier 100 not to lie against the ends of all posts 207. This is schematically illustrated for stages S2 and S3.

Compared to figure 4, stage S3 differs in that by applying vacuum to chamber 200, carrier 100 is attracted further downward. Once carrier 100 finds support on at least most of posts 207, which already can be achieved after arranging carrier 100 in stage S1 or S2, carrier 100 will at least partially seal off chamber 200. This sealing will increase the suction force that is exerted onto carrier 100, thereby removing bow and twist in carrier 100 as shown in stage S3. Stage S4 is similar to stage S4 of figure 4.

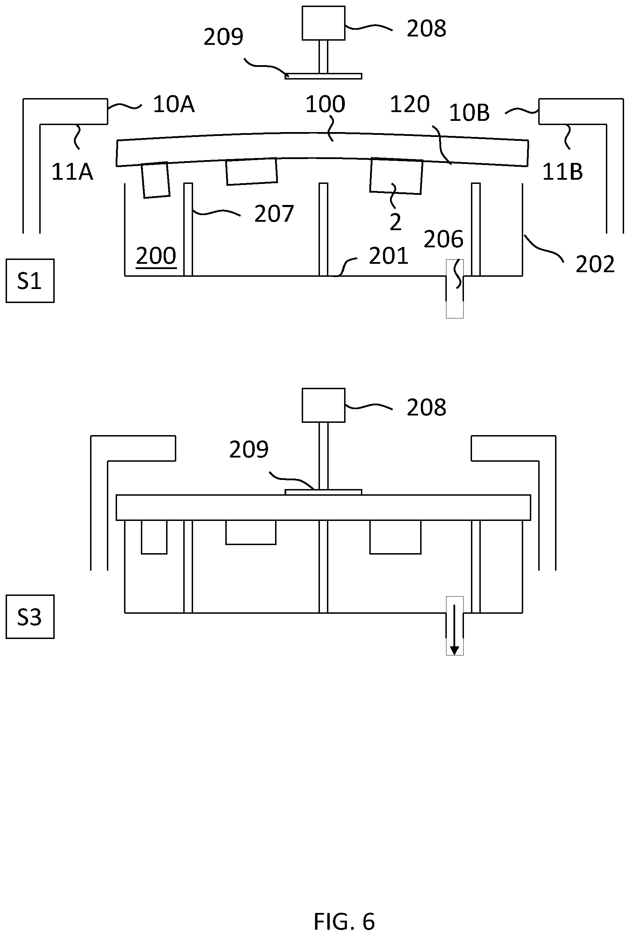

In case the suction force is insufficient to cause carrier 100 to get sufficiently close to chamber 200 such that the sealing required for the generation of suction force for overcoming bow and twist of carrier 100 can be generated, additional means can be provided. An example is shown in figure 6, which for stages S1 and S3, illustrate a pushing unit in the form of a cylinder 208 that includes a movable piston 209. By controlling cylinder 208, for example by controller 40, carrier 100 can be pushed towards chamber 200 as shown for stage S3. Once sufficient sealing is obtained, the suction force can take over. At this stage, cylinder 208 can be moved away to allow electrical components to be placed on carrier 100 at a later stage when carrier 100 is still clamped between flattening member 20 and abutment member 10A, 10B.

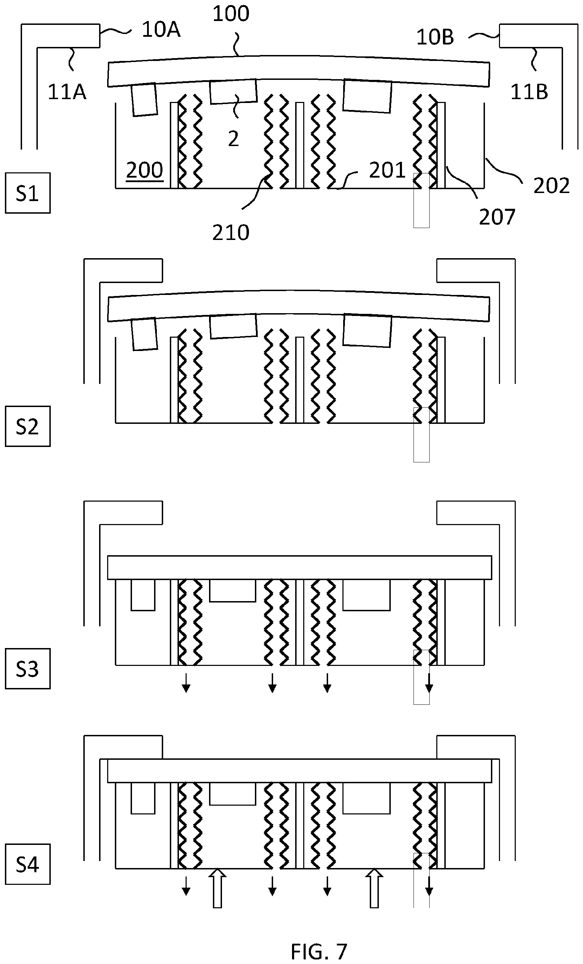

Figure 7 illustrates a further embodiment, in which chamber 200 is not fully evacuated. Instead, flexible suction cups 210 extend upwards from bottom wall 201. Near bottom wall 201, the openings of suctions cups 210 are connected to a vacuum pump (not shown). Through the other openings of suction cups 210, a suction force is exerted onto carrier 100 as shown for stage S3. This pulls carrier 100 further towards posts 207. In addition, because suction cups 210 are flexible in a direction perpendicular to bottom wall 201, the length of suction cups 210 contracts as shown for stage S3. Stage S4 in figure 7 is similar to stage 4 of figure 4 or 5.

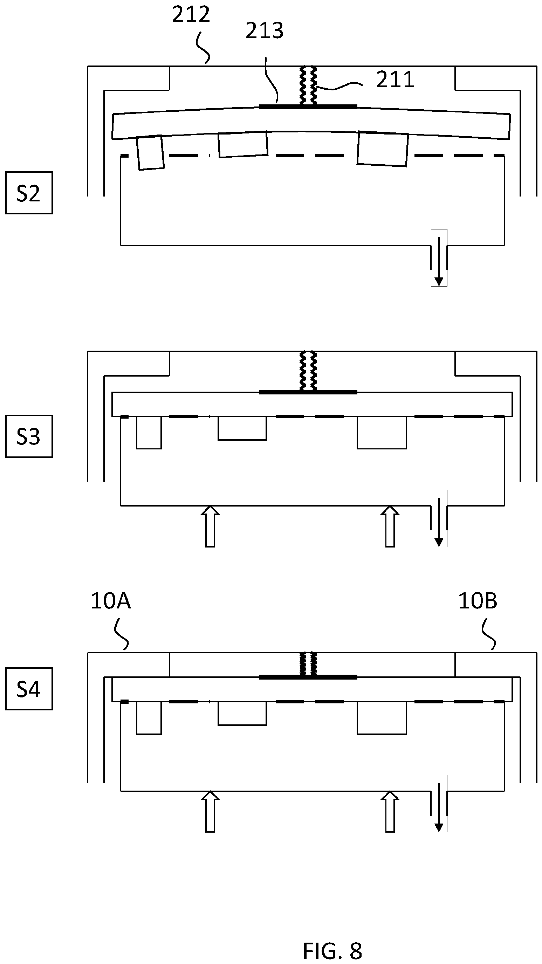

Figure 8 illustrates further additional means for flattening carrier 100 in addition to vacuum chamber 200 as shown in figure 4. The figure 8 embodiment comprises a resilient member 211 having one end fixedly connected to a support 212 and another end having a pressing surface 213. Compared to stage S3 in figure 4, stage S3 in figure 8 is different in that for flattening carrier 100, vacuum chamber 200 with carrier 100 is moved upward such that pressing surface 213 presses carrier 100 towards flattening side 21. This provides a force, in addition to the suction force, for flattening carrier 100. Typically, carrier 100 is fully flattened before carrier 100 is pressed against abutment member 10A, 10B.

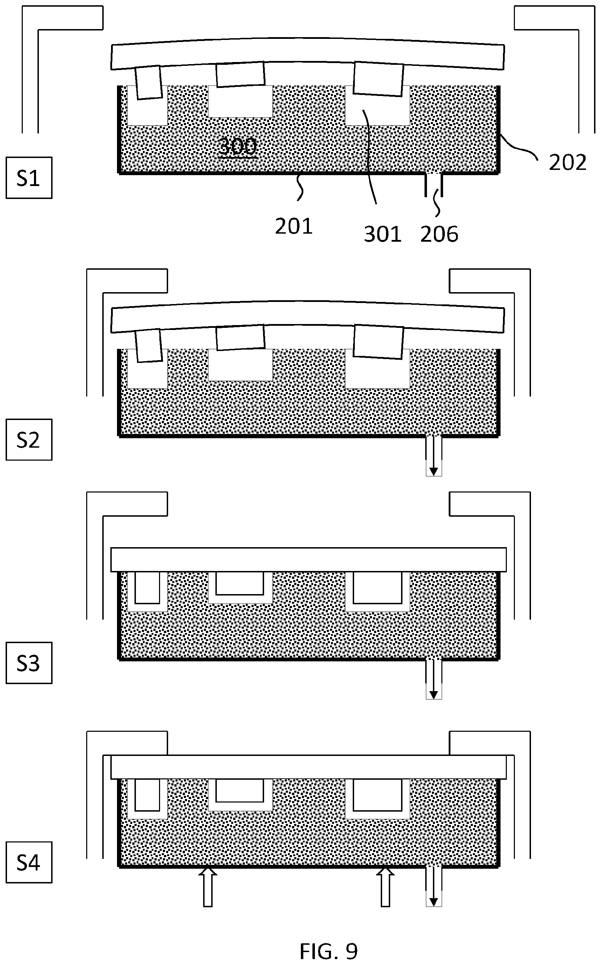

Figure 9 illustrates a further embodiment in which a chamber formed by bottom wall 201 and sidewalls 202 is filled with a porous body 300. When the vacuum pump (not shown) evacuates the chamber, the pores of porous body 300 will be evacuated. As these pores are interconnected, a suction force will be generated at the top surface of porous body 300 for flattening and/or attracting carrier 100. As shown, porous body 300 is provided with component accommodation cavities 301. Other than the function of porous body 300, which replaces the function of wall 203 and vacuum chamber 200, the operational principles of the embodiment in figure 9 are similar to those of the figure 4 embodiment.

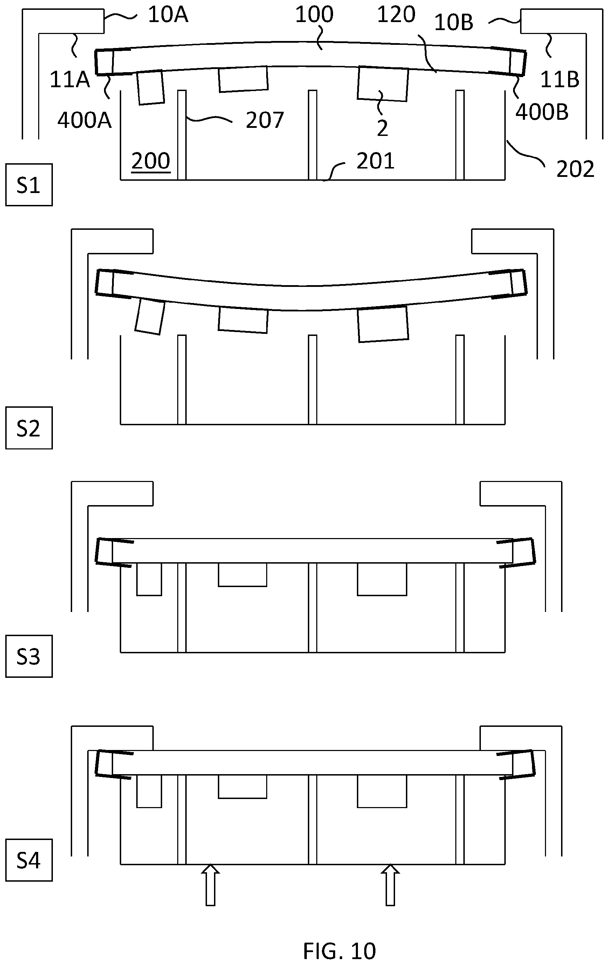

Figure 10 illustrates a flattening unit other than a vacuum pump. More in particular, flattening unit comprises a pair of edge engaging members 400A, 400B that engage the edge of carrier 100. Engaging members 400A, 400B are movably mounted. More in particular, a second actuator (not shown), which can be controlled by controller 40, can be used for rotating engaging members 400A, 400B. Alternatively, engaging members 400A, 400B are operated manually. As a result of this rotation, carrier 100 bulges towards flattening side 21. This is shown as stage S2. Thereafter, engaging members 400A, 400B and carrier 100 and chamber 200 with posts 207 are mutually moved. For example, chamber 206 with posts 207 are moved upwards while keeping carrier 100 and engaging members 400A, 400B fixed. The result of this movement is shown for stage S4. The balance between the forces onto carrier 100 exerted by posts 207 and the force exerted by engaging members 400A, 400B, causes carrier 100 to be flattened. By arranging multiple engaging members at different positions along the edges of carrier 100 and by individually controlling these engaging members, both bow and twist of carrier 100 can be corrected when this action is combined with the forces exerted by posts 207.

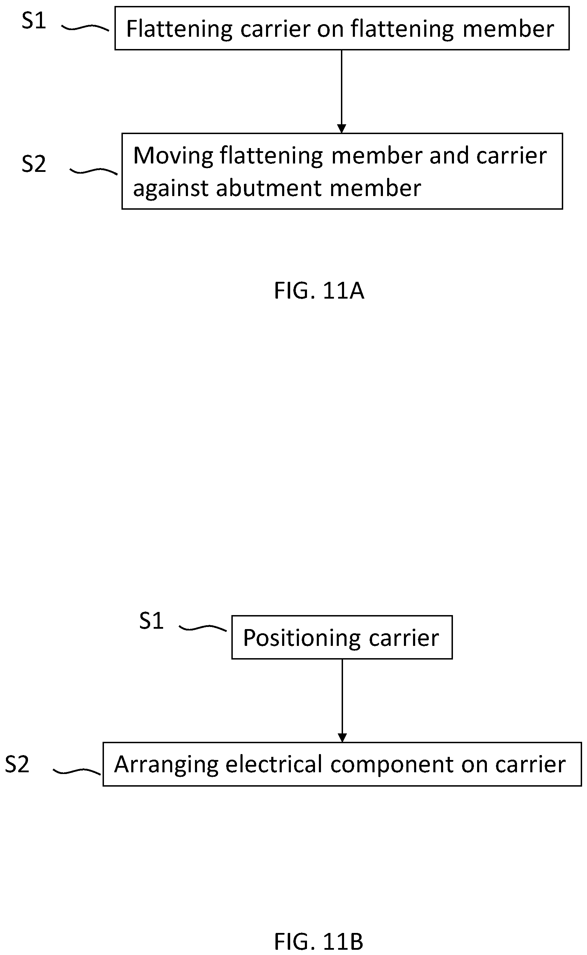

Figure 11A illustrates a method for positioning a carrier, such as a printed circuit board, in accordance with an aspect of the present disclosure. The carrier comprises a first surface and a second surface, wherein the first surface comprises a first central region on which electrical components are to be arranged, and a first edge region adjacent to the first central region. The method comprises a step S1 of flattening the carrier on a flattening side of a flattening member, and a step S2 of moving the flattening member with the carrier on the flattening side such that the carrier is pressed with its first surface against a flat abutment side of an abutment member. The step of flattening the carrier may be performed before moving the flattening member as shown. Alternatively, pressing the carrier against the flat abutment side can be performed first, which will cause an initial flattening. Further flattening may be obtained thereafter. In addition, the abutment member is configured to leave an opening exposing the first central region when the carrier is in abutment with the flat abutment side.

Figure 11B illustrates a method for arranging an electrical component on a carrier in accordance with an aspect of the present disclosure. This method comprises a step S1 of applying the positing method as described in figure 11A, and a step S2 of arranging the electrical component on the first central region of the first surface while the carrier is clamped between the abutment member and flattening member.

In the embodiments described above, several different features were discussed in relation to the flattening of the carrier. It is noted that other embodiments are possible in which at least some of these different features are combined.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. A carrier positioning device for positioning a carrier, such as a printed circuit board, wherein the carrier comprises a first surface and a second surface, wherein the first surface comprises a first central region on which electrical components are to be arranged, and a first edge region adjacent to the first central region;
wherein the carrier positioning device comprises an abutment member having a flat abutment side, a flattening member having a flattening side, a flattening unit, and a first actuator;
wherein the flattening unit is configured to flatten the carrier with its second surface against the flattening side, and wherein the first actuator is configured to move the flattening member with the carrier on the flattening side such that the carrier is pressed with its first surface against the flat abutment side;
wherein the abutment member is configured to leave an opening exposing the first central region when the carrier is in abutment with the flat abutment side to allow electrical components to be arranged on the first central region while the carrier is clamped between the abutment member and flattening member.

2. The carrier positioning device according to claim 1, wherein the flattening unit is configured to flatten the carrier before the first actuator has moved the flattening member against the flat abutment side, or wherein the first actuator is configured to move the carrier against the flat abutment side thereby obtaining an initial flattening of the carrier before the flattening unit performs a further flattening of the carrier;
wherein the carrier positioning device preferably comprises a controller for controlling the flattening unit and/or first actuator.

3. The carrier positioning device according to any of the previous claims, wherein the carrier to be positioned comprises one or more electrical components arranged on the second surface thereof, wherein the flattening side comprises one or more component accommodation openings through which the one or more electrical components arranged on the second surface of the carrier extend when the carrier is arranged on the flattening side.

4. The carrier positioning device according to any of the previous claims, wherein the flattening unit comprises a vacuum unit;
wherein the flattening side comprises one or more vacuum openings, wherein the vacuum unit is configured for exerting a suction force through the one or more vacuum openings of the flattening side to thereby flatten the carrier.

5. The carrier positioning device according to claims 2 and 3, wherein at least some of the vacuum openings are component accommodation openings or vice versa.

6. The carrier positioning device according to any of the claims 4-5, wherein the flattening member comprises a vacuum chamber of which a first wall defines the flattening side, wherein the one or more vacuum openings and the one or more component accommodation openings, if present, are provided in the first wall, and wherein the vacuum unit is configured to evacuate the vacuum chamber.

7. The carrier positioning device according to any of the claims 4-5, wherein the flattening member comprises a bottom wall, a plurality of side walls extending from the bottom wall, and a plurality of posts extending from the bottom wall towards the flattening side, wherein the bottom wall and the plurality of side walls define a chamber together with the carrier when the carrier is arranged on the plurality of posts, wherein the chamber is connected to the vacuum unit, wherein, in so far as depending claim 3, a clearance between the plurality of posts forms the one or more component accommodation openings of the flattening side.

8. The carrier positioning device according to claim 7, wherein the flattening member comprises a plurality of suction cups mounted to the bottom wall, each of said suction cups providing a channel between an inlet opening and an outlet opening of the suction cup, wherein the outlet openings of the suction cups define the one or more vacuum openings, and wherein the inlet openings are connected to the vacuum unit, wherein the suction cups are preferably flexible in a direction from the bottom wall towards the flattening side such that prior to arranging the carrier on the plurality of posts, the outlet openings of the suction cups is positioned more remote from the bottom wall than ends of the plurality of posts, and such that during flattening the carrier, a length of the suction cups has contracted.

9. The carrier positioning device according to claim 4, wherein the flattening member comprises a container having an open side and a porous body arranged in the container, wherein a first side of the porous body corresponding to the open side of the container forms the flattening side, and wherein pores of the porous body exiting on the first side of the porous body form the one or more vacuum openings, and wherein the vacuum unit is configured to evacuate the pores of the porous body.

10. The carrier positioning device according to any of the previous claims, further comprising a pushing unit configured to push the carrier towards the flattening side prior to flattening the carrier;
wherein the pushing unit preferably comprises a resilient member arranged fixedly relative to the abutment member, wherein the resilient member is configured to be compressed by the carrier when the carrier is moved towards the abutment member.

11. The carrier positioning device according to any of the claims 1-3, wherein the flattening unit comprises:
a pair of edge engaging members for engaging the edge of the carrier;
a second actuator for rotating the engaging members;
wherein the flattening member comprises a base and a plurality of posts extending from the base to the flattening side;
wherein the second actuator is configured to cause the carrier to bulge towards the flattening side, and to then mutually move the carrier with the engaging members and the flattening member to bring the plurality of posts into abutment with the second surface of the carrier such that the carrier is flattened.

12. The carrier positioning device according to any of the previous claims, wherein the abutment member is movable in a plane parallel to the flattening side between a first position in which the carrier can be arranged on the flattening side, and a second position in which the carrier can be pressed against the abutment surface.

13. A pick-and-place apparatus, comprising:
the carrier positioning device according to any of the previous claims configured for positioning a carrier; and
a pick-and-place unit configured for picking an electrical component from a supply of electrical components and for placing the picked electrical component onto the first central region of the first surface of the carrier while the positioning device clamps the carrier between its abutment member and flattening member.

14. A method for positioning a carrier, such as a printed circuit board, wherein the carrier comprises a first surface and a second surface, wherein the first surface comprises a first central region on which electrical components are to be arranged, and a first edge region adjacent to the first central region;
wherein the method comprises:
flattening the carrier on a flattening side of a flattening member; and
moving the flattening member with the carrier on the flattening side such that the carrier is pressed with its first surface against a flat abutment side of an abutment member;
wherein the abutment member is configured to leave an opening exposing the first central region when the carrier is in abutment with the flat abutment side.

15. A method for arranging an electrical component on a carrier, comprising:
the method for positioning the carrier as defined in claim 14; and
arranging the electrical component on the first central region of the first surface while the carrier is clamped between the abutment member and flattening member.
